**Europäisches Patentamt**

**European Patent Office**

**Office européen des brevets**

(19)

(11) Publication number: **0 027 047 B2**

(12) # NEW EUROPEAN PATENT SPECIFICATION

(45) Date of publication of the new patent specification: **13.03.91 Bulletin 91/11**

(51) Int. Cl.⁵: **H05K 1/00**, H05K 9/00, H05K 3/46

(21) Application number: **80303504.7**

(22) Date of filing: **03.10.80**

(54) Printed circuit board.

(30) Priority: **05.10.79 GB 7934603**

(43) Date of publication of application:
**15.04.81 Bulletin 81/15**

(45) Publication of the grant of the patent:
**10.09.86 Bulletin 86/37**

(45) Mention of the opposition decision:
**13.03.91 Bulletin 91/11**

(84) Designated Contracting States:
**AT BE CH DE FR IT LI LU NL SE**

(56) References cited:
**DE-A- 2 264 112**
**FR-A- 1 152 345**
**US-A- 3 391 457**

(56) References cited:
**US-A- 3 398 232**
**US-A- 4 047 132**
**US-A- 4 130 723**
**I.B.M. TECHNICAL DISCLOSURE BULLETIN,
vol. 11, no. 8, January 1969, NEW YORK (US),
E. STEPHANS: "Tri-lead shielding far printed
wiring", page 973**

(73) Proprietor: **UNIVERSITY COLLEGE LONDON**
**Gower Street**
**London WC1E 6BT (GB)**

(72) Inventor: **Borrill, Paul Lindsey**
**Red Tiles Avenue Road**
**Cranleigh Surrey (GB)**

(74) Representative: **Dixon, Donald Cossar et al**
**Gee & Co. Chancery House Chancery Lane**
**London WC2A 1QU (GB)**

EP 0 027 047 B2

## Description

This invention concerns improvements in printed circuit boards, and relates more especially to printed circuit boards of the kind bearing multiple conductor arrays such as may form data buses of a data processor, e.g. a microprocessor.

With the increasing miniaturisation of data processors there is a corresponding demand for printed circuit boards in which the area occupied by a given number of conductor tracks is reduced to a minimum. In the case of conductor arrays such as form data buses, and thus comprise a simple array of parallel conductor tracks, the number of tracks capable of being accommodated in a given area is theoretically limited only by the minimum width of conductive track giving acceptable resistance of the conductor and the minimum distance between adjacent tracks necessary to achieve acceptable isolation of the respective conductors. In practice, however, the termination of the conductor tracks at individual electronic components or electrical terminal connectors imposes limits upon the physical spacing of the conductors. Also, with high frequency and square wave signals such as occur in microprocessor systems, cross-talk between conductors increases significantly as the distance between conductors is reduced. Mitigation of these problems is therefore highly desirable in order to achieve improved standards of miniaturisation.

It is known that a greater number of conductor tracks can be accommodated on a printed circuit board of a given area by utilising printed circuit boards having more than one layer, the conductor tracks being distributed over the plurality of layers of the board. Moreover such conductor tracks may be connected to terminal means extending through the several layers of the board. It is further known that a shielding layer provided by a central ground plane may be interposed between layers bearing conductor tracks. US-A-3,398,232 provides an example of disclosure utilising such techniques. It concerns a printed circuit board of the kind where a circuit configuration can be built up from a selected interconnection of conductor tracks on at least two layers of the circuit board and at least one ground plane in between.

In another kind of circuit board, conventionally referred to as a "mother board" or "back plane", the intention is not to provide a specific circuit configuration, but to connect in parallel a plurality of terminal arrays that may, for example, support multi-way plugs and/or sockets to provide for the interconnection of a plurality of further individual circuit boards. In such a circuit board the conductor tracks are each individually connected to a corresponding terminal of each of the terminal arrays, rather than being interconnected to one another. The conductor tracks on the respective sides of such a circuit board extend parallel to one another, rather than at right angles as in the case of the prior arrangements referred to above. Since the object of such a circuit board is to provide as many parallel conductive paths as possible within a given area, there is a problem in routing the conductors to the terminals of the respective terminal arrays in such a manner that, for a given number of tracks on a circuit board of a given area, the maximum spacing is obtained between adjacent tracks in order to reduce crosstalk, since in each layer there are unconnected terminals of the terminal array that must be bypassed by the conductor tracks and thus there is limited space available between the unconnected terminals to accommodate free conductor tracks. In hitherto proposed constructions the requirement for the provision of a terminal array with a given number of terminals within a certain spacing, such as occupied by the DIN standard "Eurocard" arrangement, has only been met by the utilisation of non-uniform tracking arrangements such that a closer than optimum spacing has been achieved for certain of the tracks of the mother board.

Although in principle the use of a regular spacing of conductor tracks in layers with the tracks mutually parallel would provide the greatest economy of space in a so called "mother board" construction, this arrangement cannot be provided without also solving the problem of routing the conductor tracks between unused terminals of the same layer in a space saving manner.

It is accordingly an object of the invention to provide a so-called "mother board" arrangement wherein an improved layout of the conductor tracks enables a more effective utilisation of available space and thus a correspondingly reduced cross talk due to a better spacing of adjacent conductor tracks.

The invention provides a multilayer printed ciruit board comprising at least two layers each having an array of conductor tracks ; at least one layer having a conductor area forming a ground plane, said ground plane layer being disposed between said two conductor track layers ; and a plurality of arrays of electrically conductive terminal means extending orthogonally through the respective layers of the circuit board whilst being isolated from said ground plane ; each said array defining a column comprising rows of terminal means of which the total number is at least equal to the total number of conductor tracks provided by said at least two layers of the board, the columns defined by the respective terminal arrays having mutually parallel longitudinal axes extending in a first direction and being spaced apart in a second direction at right angles to said first direction ; said conductor tracks of each layer extending longitudinally in said second direction to pass through said columns in such a manner that each conductor track connects with only one terminal means of each column, by means of a corresponding terminal portion of the conductor track ; and said conductor tracks being so disposed that for each two rows of terminal means in each column three terminal means connect with terminal portions of three adjacent conductor tracks of each layer, two terminal portions being located in one row and one in the other, the portions of the conductor tracks extending between adjacent columns of the terminal arrays being rectilinear, mutually parallel, and arranged at the same relative spacing for each layer, and the arrangement further being such that the space between adjacent conductor tracks of each layer accommodate, in the regions of the circuit board between said terminal arrays, shielding tracks unconnected with terminal means of said terminal arrays, and, in the regions occupied by said columns of terminal means, individual terminal portions unconnected with conductor tracks of that layer.

The arrangement according to the invention thus not only enables a regular spacing of conductor tracks to be obtained over respective layers of the board but provides additional, capacitative shielding due to the presence of shielding tracks between linear portions of the conductor tracks.

Advantageously electrically conductive means connect each shielding track to the conductor area forming the or a ground plane at at least two points spaced apart with reference to the longitudinal axis of the shielding track whereby each shielding track together with the conductor area forms at least one electrically conductive loop. Thus the shielding tracks are able to provide additional inductive shielding by the induction therein of eddy currents by the magnetic fields set up by the signal currents in the conductor tracks.

According to a particularly advantageous embodiment of the invention, a conductor arrangement as defined above may be applied to a so-called "Eurocard" arrangement which comprises a 64 or 96-way DIN standard terminal connector, of which the 96 terminals are arranged in two or three rows respectively, each row containing 32 terminal positions, it has proved possible in accordance with the invention to provide all 96 conductor tracks connecting to the 96 terminal positions of the DIN connector, the conductor tracks being equally distributed between two layers of the printed circuit board and having shielding tracks arranged in alternation therewith. Such an arrangement provides maximum utilisation of the two layers of the board having the electrical conductors, and enables the location thereof within the area dictated by the standard terminal connections.

This invention is illustrated by way of example in the accompanying drawings, in which :

Figure 1 is a fragmentary plan view showing the relevant part of a conductor and terminal arrangement of one layer of a typical three-layer printed circuit board in accordance with the invention, viewed from the component side of the board, in this figure only 84 "bussed" tracks were chosen in order to provide increased current carrying capacity on the outer rows of the connector,

Figure 2 is a fragmentary plan view showing the arrangement of the conductive layer of a second layer of the printed circuit board, providing a ground plane,

Figure 3 is a fragmentary plan view, similar to Figure 1, showing the conductor and terminal arrangement of the third layer of the printed circuit board, viewed from the solder-side of the board, i.e. viewed from the opposite side of the board from that of the view shown in Figure 1, and

Figure 4 is a diagrammatic perspective view illustrating the relationship between the respective conductor arrangements of the layers of Figures 1 to 3, over a small fragment of the area of the printed circuit board.

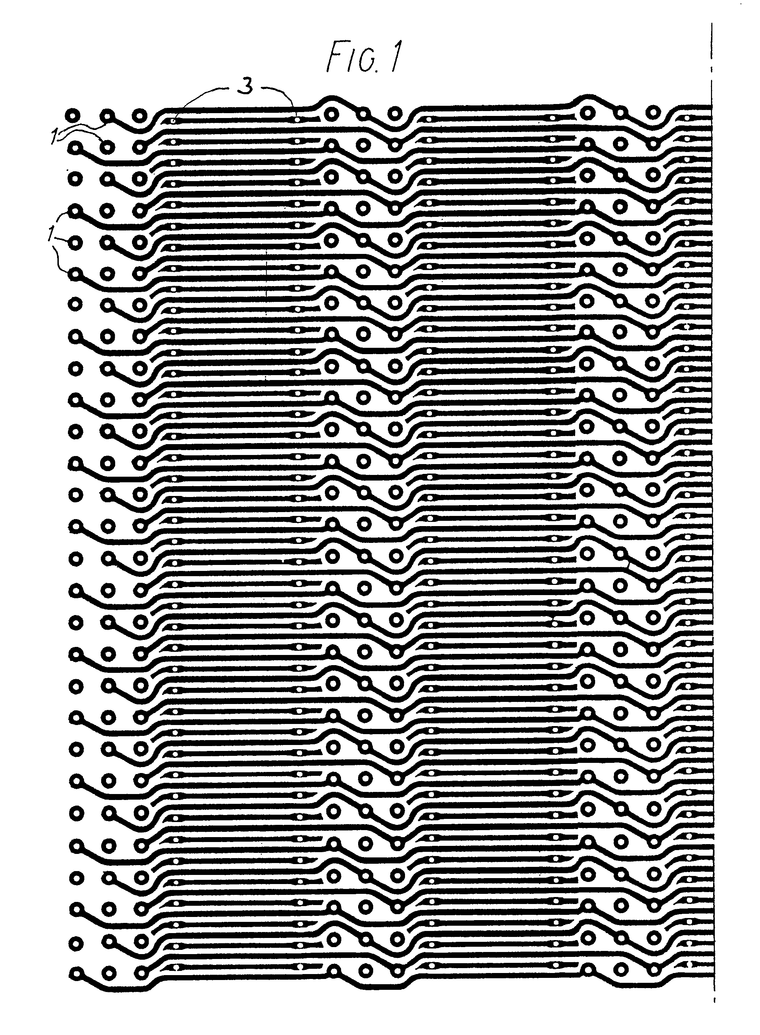

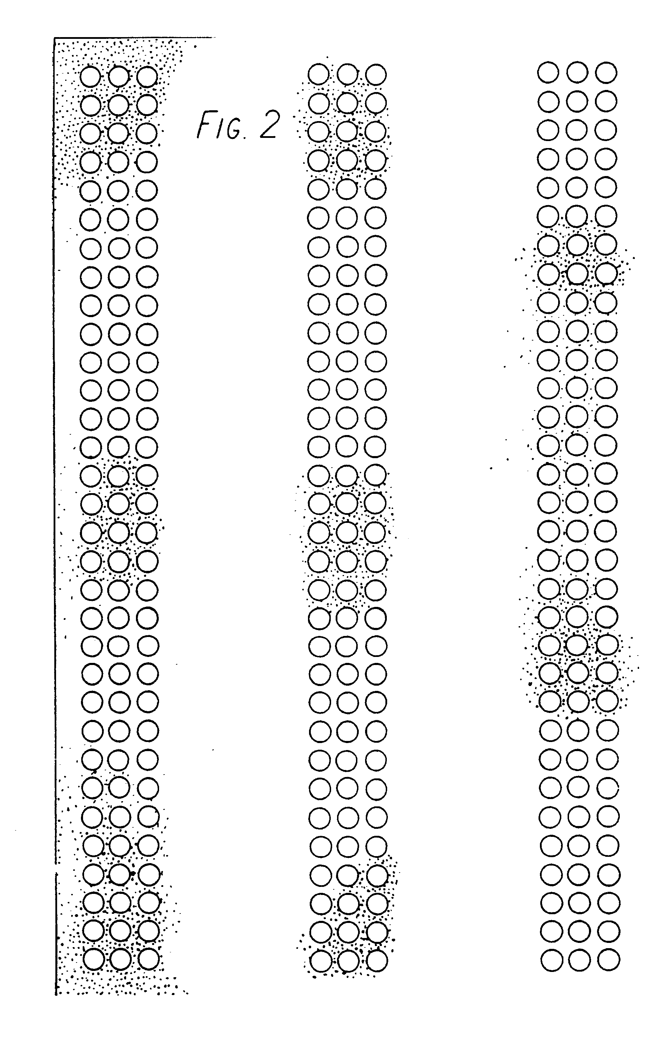

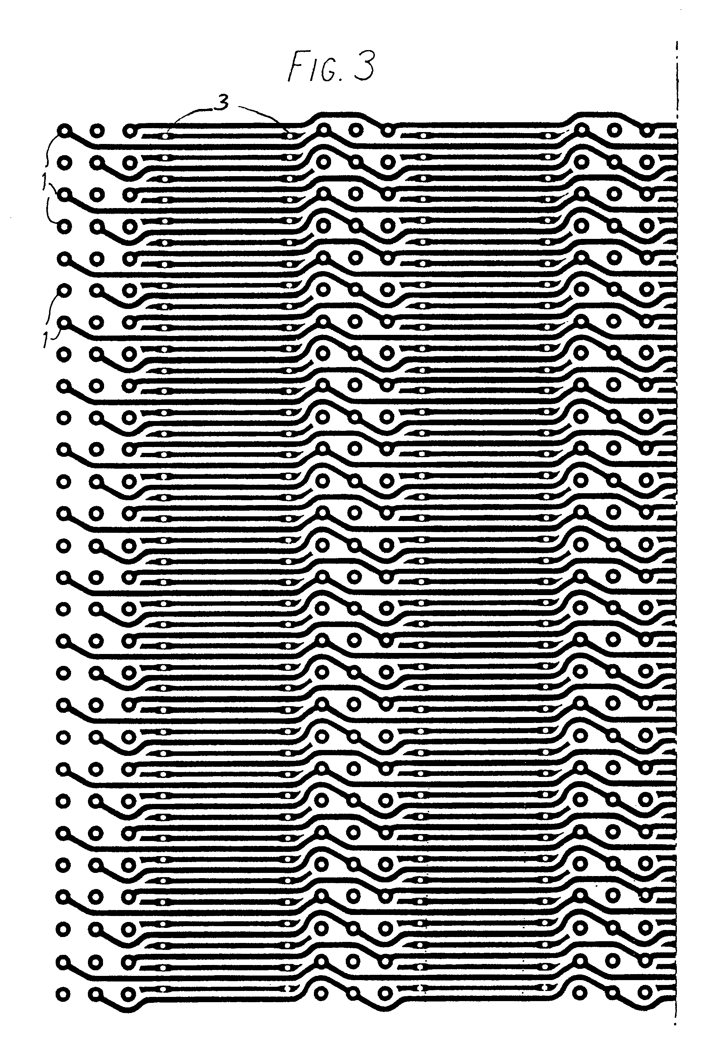

Referring to Figures 1 to 3 of the drawings, it will be seen that the conductor arrangements shown therein comprise, at least in the case of Figures 1 and 3, a repetitive pattern extending transversely and lengthwise of the printed circuit board. In the case of the ground plane of Figure 2, the conductive layers of the board provides a continuous conductive area which is interrupted only by clearance holes providing for electrical connection between the conductors of the layers of Figures 1 and 3. The complete printed circuit board comprises the conductive layers of Figures 1 and 3 arranged in back-to-back relationship, with the conductive pattern of Figure 2 arranged as an intermediate ground plane sandwiched therebetween. The terminal locations indicated at 1 in Figures 1 and 3 are located in register with one another and interconnected by plated-through holes which pass through non-conductive areas 2 of the ground plane, and further plated-through holes indicated at 3 in Figures 1 and 3 provide electrical connection between shielding tracks of Figures 1 and 3, and the conductive area of the ground plane of Figure 2, as will be described in more detail below.

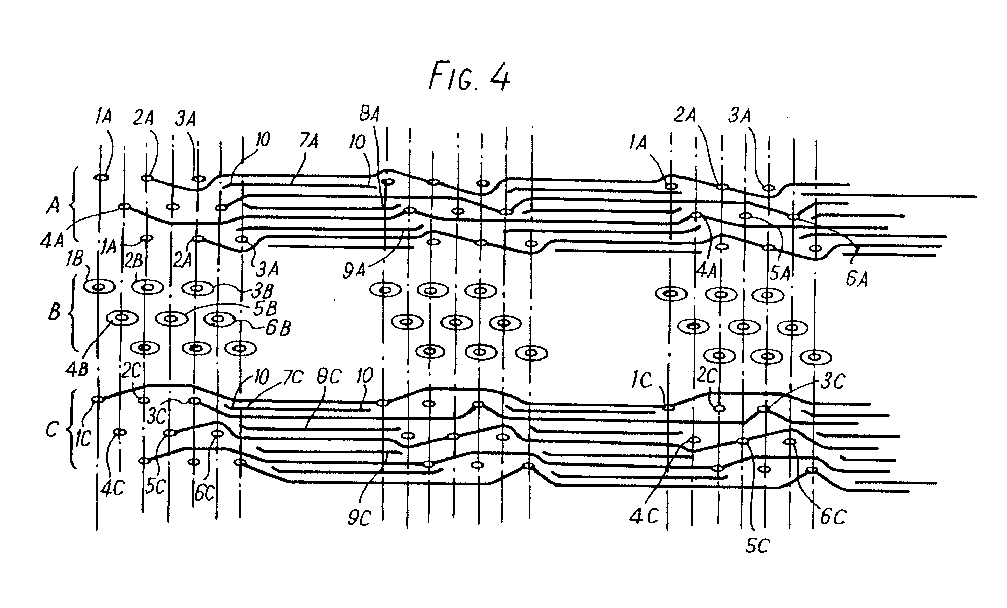

Referring to Figure 4, the relationship between the respective conductive patterns of the layers of Figures 1 to 3 is illustrated in more detail, wherein a small fragment of the repetitive pattern of the respective layers is shown in an exploded perspective diagrammatic view. In Figure 4, the area A represents a fragment of the pattern shown in Figures 1 the area B represents a fragment of the pattern shown in Figure 2, and the area C represents a fragment of the pattern shown in Figure 3. The left-hand edge of the drawing illustrates the conductor pattern at a terminal edge of the printed circuit board, whereas the conductor pattern extending towards the right-hand edge of the drawing is repeated continuously until it terminates in an edge pattern (not shown), in symmetry with that at the left-hand edge of the drawing. The pattern is also repeated in the transverse direction, as can be seen by reference to Figures 1 to 3. Each end of the tracking arrangement may alternatively be terminated by an electrical network which forms a termination impedance matched to the characteristic impedance of the tracks when considered as transmission lines.

The conductor tracks of the upper and lower layers of the printed circuit board shown in Figures 1 and 3 respectively effectively connect in parallel a plurality of terminal locations which may be subdivided into groups of six as illustrated in Figure 4 at 1A to 6A and 1C to 6C for the upper and lower layers respectively. The conductors of the upper tracks are directly connected to terminal locations 2A, 4A and 6A respectively, whereas those of the lower tracks are connected to locations 1C, 3C and 5C respectively. The unconnected locations 1A, 3A and 5A of the upper layer are electrically connected by plated-through holes to location 1C, 3C and 5C of the lower track, whereas the corresponding unconnected areas 2C, 4C and 6C of the lower track are likewise connected to the areas 2A, 4A and 6A of the upper track. Thus of each group of six terminals of a terminal connector secured to the printed circuit board, three are connected to conductor tracks of the upper layers and three to conductor tracks of the lower layers, so that the conductor tracks connected to the terminal of the connector are evenly distributed between the upper and lower layers of the printed circuit board. This fact in itself would aid the minimisation of cross-talk between adjacent conductors because the spacing between such conductors is maximised, indeed it is only because the spacing has been maximised in this way, that it is physically possible to interpose shielding tracks between conducting tracks on a backplane using the DIN 41612 connector leaving sufficient space to achieve acceptable isolation between all tracks.

As mentioned above, between the upper and lower layers of the printed circuit board which provide the arrays of conductor tracks, there is interposed a ground plane of which the conductive pattern is illustrated at B in Figure 4. The ground plane comprises a continuous layer of electrically conductive material which is broken only by non-conductive areas 1B to 6B at the centre of which are located apertures registering with the terminal areas 1A to 6A and 1C to 6C and accommodating the plated-through electrical connection between the upper and lower layers. The non-electrically conductive areas 1B to 6B are provided solely in order to avoid any unintentional electrical connection between the upper and lower terminal locations 1A to 6A, 1C to 6C and the electrically conductive layer of the ground plane.

Between each adjacent pair of electrically conductive tracks of the upper and lower layers A and C, there is arranged a shielding track indicated in Figure 4 at 7A, 8A and 9A and 7C, 8C and 9C, respectively. Adjacent to each end of the shielding tracks 7A, 8A and 9A and 7C, 8C and 9C are arranged apertures 10 penetrating the printed circuit board, which apertures provide for platedthrough connections between the corresponding point on the shielding tracks and the electrically conductive layer of the ground plane. Thus, each of the shield tracks 7A to 9A, 7C to 9C, in conjunction with the conductive layer of the ground plane B forms a closed-electrically conductive loop. Thus, electrically conductive shield tracks provide both capacitative shielding between adjacent conductive tracks, especially due to their electrical connection, via the ground plane, to earth, and inductive shielding of adjacent conductive tracks, due to the fact that eddy currents are induced therein by the electromagnetic fields set up by signal currents in the said conductor tracks. The said electromagnetic fields are thus absorbed within the electrically conductive loops provided by the shield tracks and inductive cross-talk between adjacent conductive tracks is correspondingly reduced.

From the above disclosure it will be appreciated that there has been provided a novel printed circuit board arrangement which provides optimum utilisation of the available printed circuit board area both as regards the density of distribution of the conductor tracks and as regards the utilisation of the intermediate shielding tracks to counteract cross-talk.

It will be appreciated that various alterations and modifications to the preferred embodiment of the invention described above may be made without departing from the scope of the invention as defined in the appended Claims.

In particular, although the distribution of conductor tracks between upper and lower layers of the printed circuit board provides for optimum distribution of the conductor tracks, this may be dispensed with in cases where the required density of conductor distribution can be provided by a single conductive layer, and the reduction of cross-talk by means of the intermediate shielding track is of greater importance.

In cases where the distribution of conductor tracks between the upper and lower layers, in order to achieve optimum spacing of the conductor tracks, is of greater importance, such an arrangement may be utilised without the necessity for intermediate shielding tracks.

If desired, the number of layers of the circuit board may be increased above three, for example to provide for additional ground planes at the outer layers of a five layer board.

In addition the connection of each terminal on the connector to the corresponding terminal on all other connectors may be made on either side of the printed circuit board, or even, alternately on one side then on the other side between all the conductors on the printed circuit baord. One further possible tracking arrangement exists which could have particular advantages in certain circumstances : the connection of tracks between all connectors along the printed circuit board could be made alternatively on one side, then the other between all the connectors such that an effective spiral of two or more conducting tracks takes place along the printed circuit board, this arrangement provides a "twisted pair" like transmission line down the length of the printed circuit board. The twist being provided by the effective crossing over of conducting tracks at or near each plated-through hole.

## Claims

1. A multilayer printed circuit board comprising at least two layers (A, C) each having an array of conductor tracks ; at least one layer (B) having a conductor area forming a ground plane, said ground plane layer (B) being disposed between said two conductor track layers (A, C) ; and a plurality of arrays of electrically conductive terminal means extending orthogonally through the respective layers (A, B, C) of the circuit board whilst being isolated from said ground plane ; each said array defining a column comprising rows of terminal means of which the total number is at least equal to the total number of conductor tracks provided by said at least two layers (A, C) of the board, the columns defined by the respective terminal arrays having mutually parallel longitudinal axes extending in a first direction and being spaced apart in a second direction at right angles to said first direction ; said conductor tracks of each layer extending longitudinally in said second direction to pass through said columns in such a manner that each conductor track connects with only one terminal means of each column, by means of a corresponding terminal portion (2A, 4A, 6A ; 1C, 3C, 5C) of the conductor track ; and said conductor tracks being so disposed that for each two rows of terminal means in each column three terminal means connect with terminal portions (2A, 4A, 6A ; 1C, 3C, 5C) of three adjacent conductor tracks of each layer, two terminal portions (4A, 6A ; 1C, 3C) being located in one row and one (2A ; 5C) in the other, the portions of the conductor tracks extending between adjacent columns of the terminal arrays being rectilinear, mutually parallel, and arranged at the same relative spacing for each layer, and the arrangement further being such that the spaces between adjacent conductor tracks of each layer accommodate, in the regions of the circuit board between said terminal arrays, shielding tracks (7, 8, 9) unconnected with terminal means of said terminal arrays, and, in the regions occupied by said columns of terminal means, individual terminal means (1A, 3A, 5A, 2C, 4C, 6C) unconnected with conductor tracks of that layer.

2. A printed circuit board as claimed in Claim 1, characterised in that electrically conductive means connect each shielding track (7A, 8A, 9A ; 7C, 8C, 9C) to the conductor area forming the or a ground plane at at least two points spaced apart, whereby each shielding track together with the conductor area forms at least one electrically conductive loop.

3. A printed circuit board according to Claim 1 or 2, characterised in that it comprises three layers (A, B, C) of which the two outer layers (A, C) form said conductor track layers and the intermediate layer (B) forms said ground plane, said linear conductors of said outer layers comprising microstrip transmission lines.

4. A printed circuit board according to any one of Claims 1-3, characterised in that the shielding tracks (7A, 8A, 9A ; 7C, 8C, 9C) of the respective conductor track layers are arranged in superimposition and that the superimposed shielding tracks (7A, 7C ; 8A, 8C ; 9A, 9C) are connected to the or a ground plane by common electrically conductive means extending orthogonally through the layers of the circuit board at said at least two points.

5. A printed circuit as claimed in any one of Claims 1-4, characterised in that it comprises two said conductor track layers (A, C) and that each row of each column of terminal means has three individual terminal means.

## Ansprüche

1. Gedruckte Schaltplatte aus wenigstens zwei Schichten (A, C) mit je einem Feld von Leiterbahnen und mindestens einer Schicht (B) mit einer Leiterfläche zur Bildung einer Grundebene zwischen den beiden Leiterbahnschichten (A, C) und mit einer Anzahl von Feldern elektrisch leitender Anschlußpunkte, die sich orthogonal durch die entsprechenden Schichten (A, B, C) der Schaltplatte erstrecken und von der Grundebene isoliert sind, wobei jedes Feld eine Serie mit Reihen von Anschlußpunkten bezeichnet, deren Gesamtzahl mindestens gleich der Gesamtzahl der an den mindestens zwei Schichten (A, C) der Platte angeordneten Leiterbahnen ist, wobei weiter die durch die entsprechenden Anschlußfelder bezeichneten Serien gegenseitig parallele Längsachsen aufweisen und in einer ersten Richtung verlaufen und in einer zweiten Richtung rechtwinklig zu der ersten Richtung beabstandet sind, wobei ferner die Leiterbahnen einer jeden Schicht in der zweiten Richtung längs verlaufen und die Serien in solcher Weise durchlaufen, daß jede Leiterbahn mit lediglich einem Anschlußpunkt jeder Serie durch ein entsprechendes Anschlußelement (2A, 4A, 6A ; 1C, 3C, 5C) der Leiterbahn verbunden ist, und wobei schließlich die Leiterbahnen derart angeordnet sind, daß für je zwei Reihen von Anschlußpunkten in jeder Serie drei Anschlußpunkte mit Anschlußelementen (2A, 4A, 6A; 1C, 3C, 5C) dreier benachbarter Leiterbahnen jeder Schicht verbunden sind, wovon zwei Anschlußelemente (4A, 6A ; 1C, 3C) in einer Reihe und eines (2A, 5C) in der anderen Reihe angeordnet sind und die sich zwischen den benachbarten Serien der Klemmenfelder erstreckenden Leiterbahnen geradlinig, gegenseitig parallel verlaufen und im gleichen relativen Abstand auf jeder Schicht angeordnet sind und die Anordnung so getroffen ist, daß die Abstände zwischen benachbarten Leiterbahnen jeder Schicht in den Bereichen der Schaltplatte zwischen den Anschlußfeldern Abschirmbahnen (7, 8, 9) aufnehmen, die nicht mit Anschlußelementen der Anschlußfelder verbunden sind und in den die Serien der Anschlußpunkte aufnehmenden Bereichen einzelne Anschlußpunkte (1A, 3A, 5A ; 2C, 4C, 6C) aufnehmen, die nicht mit den Leiterbahnen der Schicht verbunden sind.

2. Gedruckte Schaltplatte nach Anspruch 1, dadurch gekennzeichnet, daß elektrische Leiter jedes Abschirmfeld (7A, 8A, 9A ; 7C, 8C, 9C) mit der eine Grundebene bildenden Leiterfläche an mindestens zwei in Abstand voneinander liegenden Punkten verbinden, wobei jede Abschirmbahn zusammen mit der Leiterfläche mindestens eine elektrisch leitende Schleife bildet.

3. Gedruckte Schaltplatte nach Anspruch 1 oder 2, dadurch gekennzeichnet, daß sie drei Schichten (A, B, C) aufweist, von denen die beiden äußeren Schichten (A, C) die Schichten für die Leiterbahnen bilden und die Zwischenschicht (B) die Grundebene bildet und die linearen Leiter der äußeren Schichten aus Mikroleitern bestehende Übertragungsleitungen aufweisen.

4. Gedruckte Schaltplatte nach einem der Ansprüche 1 bis 3, dadurch gekennzeichnet, daß die Abschirmbahnen (7A, 8A, 9A ; 7C, 8C, 9C) der Leiterbahnschichten in Überlagerung angeordnet sind und die überlagerten Abschirmbahnen (7A, 7C ; 8A, 8C ; 9A, 9C) mit einer Grundebene durch gemeinsame elektrische Leitelemente verbunden sind, die sich orthogonal durch die Schichten der Schaltplatte an mindestens zwei Punkten erstrecken.

5. Gedruckte Schaltplatte nach einem der Ansprüche 1 bis 4, dadurch gekennzeichnet, daß sie zwei Schichten mit Leiterbahnen (A, C) aufweist und jede Reihe einer jeden Serie der Anschlußpunkte drei einzelne Anschlußelemente aufweist.

## Revendications

1. Plaquette de circuit imprimé multicouches comportant au moins deux couches (A, C) ayant chacune une rangée de pistes conductrices, une couche (B) au moins ayant une zone conductrice formant un plan de terre, cette couche de plan de terre (B) étant disposée entre les deux couches de pistes conductrices (A, C), et une multiplicité de rangées de moyens de connexion électriquement conducteurs s'étendant perpendiculairement à travers les couches respectives (A, B, C) de la plaquette de circuit tout en étant isolés de ce plan de terre, chacune de ces rangées définissant une colonne comportant des rangs de moyens de connexion dont le nombre total est au moins égal au nombre total de pistes conductrices procurées dans au moins les deux couches (A, C) de la plaquette, les colonnes définies par les rangées de moyens de connexion respectives ayant des axes longitudinaux parallèles les uns aux autres et s'étendant dans une première direction et étant espacées dans une deuxième direction perpendiculaire à la première direction, les pistes conductrices de chaque couche s'étendant longitudinalement dans la deuxième direction pour passer à travers les colonnes, de manière que chaque piste conductrice se raccorde à seulement un moyen de connexion de chaque colonne au moyen d'une portion de connexion correspondante (2A, 4A, 6A ; 1C, 3C, 5C) de la piste conductrice, les pistes conductrices étant disposées de telle sorte que, pour chaque deux rangs de moyens de connexion dans chaque colonne, trois moyens de,connexion se raccordent aux portions de connexion (2A, 4A, 6A ; 1C, 3C, 5C) de trois pistes conductrices adjacentes de chaque couche, deux portions de connexion (4A, 6A ; 1C, 3C) étant disposées dans un rang et une portion de connexion (2A ; 5C) dans l'autre, les portions des pistes conductrices s'étendant entre des colonnes adjacentes des rangées de moyens de connexion étant rectilignes, parallèles les unes aux autres et disposées au même espacement relatif pour chaque couche, la disposition étant telle que les espaces entre des pistes conductrices adjacentes de chaque couche reçoivent, dans les régions de la plaquette de circuit entre les rangées des moyens de connexion, des pistes de blindage (7, 8, 9) non raccordées aux moyens de connexion des rangées de moyens de connexion et, dans les régions occupées par ces colonnes de moyens de connexion, des moyens de connexion individuelles (1A, 3A, 5A, 2C, 4C, 6C) non raccordées aux pistes conductrices de cette couche.

2. Plaquette de circuit imprimé selon la revendication 1, caractérisée en ce que des moyens électriquement conducteurs raccordent chaque piste de blindage (7A, 8A, 9A ; 7C, 8C, 9C) à la zone conductrice formant le ou un plan de terre en au moins deux points espacés, d'où il résulte que chaque piste de blindage forme avec la zone conductrice au moins une boucle électriquement conductrice.

3. Plaquette de circuit imprimé selon la revendication 1 ou la revendication 2, caractérisée en ce qu'elle comporte trois couches (A, B, C) dont les deux couches extérieures (A, C) forment les couches de pistes conductrices et la couche intermédiaire (B) forme le plan de terre, les conducteurs rectilignes des couches extérieures comportant des lignes de transmission à microbandes.

4. Plaquette de circuit imprimé selon l'une quelconque des revendications 1 à 3, caractérisée en ce que les pistes de blindage (7A, 8A, 9A ; 7C, 8C, 9C) des couches de pistes conductrices respectives sont disposées en superposition et que les couches de blindage superposées (7A, 7C ; 8A, 8C ; 9A, 9C) sont raccordées aux ou à un plan de terre par des moyens électriquement conducteurs communs s'étendant perpendiculairement à travers les couches de la plaquette de circuit en au moins deux points.

5. Plaquette de circuit imprimé selon l'une quelconque des revendications 1 à 4, caractérisée en ce qu'elle comprend deux couches de pistes conductrices (A, C) et que chaque rang de chaque colonne de moyens de connexion a trois moyens de connexion individuels.

FIG. 1

FIG. 2

# FIG. 3

FIG. 4